# EUROPEAN PATENT SPECIFICATION

(11) **EP 2 302 092 B1**
(45) Date of publication and mention of the grant of the patent: **23.12.2015**
(21) Application number: 09766644.0
(22) Date of filing: 16.06.2009
(51) Int. Cl.: C23C 14/34, C23C 14/50, H01J 37/32, H01L 21/285, H01J 37/34

(54) **BIAS SPUTTERING APPARATUS**
BIAS-SPUTTERVORRICHTUNG
APPAREIL POLARISEUR PULVÉRISATEUR

(30) Priority: 17.06.2008 JP 2008157879
(43) Date of publication of application: 30.03.2011
(73) Proprietor: Shincron Co., Ltd., Kanagawa 220-8680 (JP)
(72) Inventor: SUGAWARA, Satoshi, Yokohama-shi Kanagawa 220-8680 (JP); ENAMI, Yasuhiro, Yokohama-shi Kanagawa 220-8680 (JP); TAKAHASHI, Kazuki, Yokohama-shi Kanagawa 220-8680 (JP); KUMAGAWA, Susumu, Yokohama-shi Kanagawa 220-8680 (JP); JIANG, Yousong, Yokohama-shi Kanagawa 220-8680 (JP); SHIONO, Ichiro, Yokohama-shi Kanagawa 220-8680 (JP); TAKASAKA, Yoshihiro, Yokohama-shi Kanagawa 220-8680 (JP)
(74) Representative: Grünecker Patent- und Rechtsanwälte PartG mbB
(86) International application number: PCT/JP2009/060936
(87) International publication number: WO 2009/154196

(56) References cited:
- JP-A- 4 305 081
- JP-A- 8 315 432
- JP-A- H06 256 940
- JP-A- H06 256 940
- US-A- 4 986 890

## Description

### Technical Field

The present invention relates to a bias sputtering device, particularly to a bias sputtering device provided with a self-revolving type substrate holder.

### Background Art

In a generally used bias sputtering device, sputtering power is respectively applied to a substrate and a target both arranged in a vacuum chamber so as to face each other. By generating plasma between the substrate and the target, a thin film can be formed while sputtering a film formation material in a shape of the target with ions (for example, refer to Patent Document 1).

In a bias sputtering device, various measures are implemented for improving quality and yield of a thin film device such as an optical device and a semiconductor device.

For example, as an attempt to reduce manufacturing cost, by providing a deposition preventing plate, time required for removing a thin film material deposited in a vacuum chamber (chamber maintenance time) is shortened so as to improve an equipment operation rate (for example, refer to Patent Document 2).

There are a method of stabilizing film thickness by controlling film formation time and film formation power based on real-time measurement results of the film thickness using a film thickness monitor, a method of forming films while turning and revolving a substrate holder, or an attempt to highly precisely control the film thickness by providing a correcting plate mechanism between a substrate holder and a target (for example, refer to Patent Documents 3 to 6).

Further, a method of using a high frequency (RF) power source as a sputtering power source in place of a DC power source is called RF bias sputtering, which enables sputtering of metal and an insulating material by using the high frequency power source (for example, refer to Patent Documents 1, 2, 4).

Patent Document 1: Japanese Patent Application Publication No. 2000-129441
Patent Document 2: Japanese Patent Application Publication No. 1997-087835
Patent Document 3: Japanese Patent Application Publication No. 2002-030435
Patent Document 4: Japanese Patent Application Publication No. 2006-265692
Patent Document 5: Japanese Patent Application Publication No. 1995-292471
Patent Document 6: Japanese Patent Application Publication No. 2006-070330
Patent Document 7: Japanese Patent Application Publication JPH06256940 A

### Disclosure of the Invention

### Problems to be Solved by the Invention

In the bias sputtering device, since the sputtering power source is applied to the entire substrate holder, the film formation material sputtered from the target is also adhered and deposited onto a part of the substrate holder. The film formation material adhered to the part other than the substrate (such as the substrate holder) tends to be deposited with non-uniform film thickness in the vicinity of a convex and concave part on a surface of the substrate holder and a step of an attachment part of the substrate. Particularly, in a case where a non-uniform film laminated in the vicinity of the substrate is exfoliated due to ion collisions caused by a bombardment process in film formation, this exfoliated film is adhered to the substrate in the film formation as a foreign substance so as to cause film formation failure.

In the bias sputtering device provided with a large dome shaped substrate holder, an area of the substrate holder to which the sputtering power source is applied is large. Thus, it is difficult to increase electric potential of a self-bias of the entire substrate holder. Particularly, as in a technique shown in Patent Document 4 or 5, in the self-revolving type sputtering device in which the substrate holder is provided with a turning and revolving mechanism, the substrate holder is enlarged and complicated. Thus, it is difficult to generate high electric potential on the substrate, and there is a problem that the foreign substance is generated due to the ion collisions.

In consideration with the above problems, an object of the present invention is to provide a bias sputtering device capable of manufacturing a thin film device having a high cleanliness level and high precision.

Another object of the present invention is to provide a bias sputtering device capable of reducing the manufacturing cost of the thin film device.

### Means for Solving the Problems

The above problems are solved by a bias sputtering device of claim 1, including a substrate holder having a self-revolving mechanism for supporting substrates in a vacuum chamber, substrate electrodes provided on the side of the substrate holder, and targets arranged so as to face the substrates, the bias sputtering device for applying electric power to the substrate electrodes and the targets and generating a plasma between the substrate electrodes and the targets, so that thin films are formed on surfaces of the substrates, wherein the substrate electrodes are provided only on the side of back surfaces of the substrates supported by the substrate holder, and the substrate electrodes and the substrates are arranged so as to be distant from each other by a predetermined distance.

In such a way, with the bias sputtering device according to the present invention, the substrate electrodes are provided only on the side of the back surfaces of the substrates supported by the substrate holder, and the substrate electrodes and the substrates are arranged so as to be distant from each other by the predetermined distance. Thus, the electric power is supplied only to the back surfaces of the substrates attached to the substrate holder. Therefore, ranges of values of voltage and the electric power to be supplied to the substrates can be set higher than conventional values, so that film quality can be improved to be fine and process time can be shortened.

By reducing film formation materials adhered to the substrate holder of the bias sputtering device according to the present invention, generation of foreign substances by exfoliation of a part of films due to ion collisions in film formation is suppressed, so that a cleanliness level of the films can be improved.

It should be noted that the "back surfaces" of the substrates indicate surfaces which are not sputtering surfaces, that is, surfaces on the opposite side of surfaces facing the targets.

Specifically and preferably, as in claim 2, the predetermined distance between the substrate electrodes and the substrates is not less than 0.5 mm and not more than 10 mm.

In such a way, since the predetermined distance between the substrate electrodes and the substrates is not less than 0.5 mm and not more than 10 mm, the substrates can be arranged in ranges where a self-bias effect emerging in the substrate electrodes is reflected. By changing the distance between the substrate electrodes and the substrates, the self-bias effect to be reflected to the substrates can be adjusted.

Specifically and further preferably, as in claim 3, the substrate holder has a revolving member rotated relative to the vacuum chamber, and turning holders rotated relative to the revolving member, the turning holders being capable of supporting the substrates, and the substrate electrodes are supported on one ends of wiring members directly or indirectly connected to an external power source on the other ends, and insulated from both of the turning holders and the revolving member.

In such a way, the substrate electrodes are insulated from both of the turning holders and the revolving member, and arranged so as to be directly or indirectly connected to the external power source (specifically, connected on the side of the revolving member). Thus, there are no electric contact between the substrate electrodes and the turning holders. Therefore, the generation of the foreign substances due to contact between the substrate electrodes and the turning holders can be prevented, so that the cleanliness level of the films can be improved.

It should be noted that the "side of the revolving member" indicates the side of all the related members for driving and rotating the revolving member in a broad sense. More specifically, the other ends of the wiring members are connected to a power receiving member fixed to a rotation shaft passing through a center part of the revolving member in order to rotate the revolving member.

Further specifically and preferably, as in claim 4, the substrate holder has a revolving member rotated relative to the vacuum chamber, and turning holders rotated relative to the revolving member, the turning holders being capable of supporting the substrates, the substrate electrodes are supported on one ends of wiring members directly or indirectly connected to an external power source on the other ends, and insulated from both of the turning holders and the revolving member, and the predetermined distance between the substrate electrodes and the substrates is adjustable by changing attachment positions of the wiring members to the revolving member.

With the above configuration, by changing attachment height of the wiring members to the revolving member, the distance between the substrate electrodes and the substrates can be arbitrarily changed, so that the substrates can be arranged in the ranges where the self-bias effect emerging in the substrate electrodes is reflected. By changing the distance between the substrate electrodes and the substrates, the self-bias effect to be reflected to the substrates can be adjusted.

Preferably, as in claim 5, the substrate holder has a revolving member rotated relative to the vacuum chamber, and turning holders rotated relative to the revolving member, the turning holders being capable of supporting the substrates, the substrate electrodes are supported on one ends of wiring members directly or indirectly connected to an external power source on the other ends, and insulated from both of the turning holders and the revolving member, the predetermined distance between the substrate electrodes and the substrates is adjustable by changing attachment positions of the wiring members to the revolving member, and the turning holders respectively have insulating coatings on surfaces in predetermined parts thereof in the vicinity of the substrate electrodes.

In such a way, the turning holders respectively have the insulating coatings on the surfaces in the predetermined parts thereof in the vicinity of the substrate electrodes. Therefore, electric discharge with the substrate electrodes can be prevented, and the substrate electrodes having size so as to face the substantially entire back surfaces of the substrates can be arranged. Thus, uniform film formation conditions can be obtained for the entire substrates, so that highly uniform and highly precise film formation can be performed.

Further, preferably, as in claim 6, the substrate holder has a revolving member rotated relative to the vacuum chamber, and turning holders rotated relative to the revolving member, the turning holders being capable of supporting the substrates, the turning holders are insulated from the revolving member, and the substrate electrodes are attached on the side of the turning holders.

In such a way, since the turning holders are insulated from the revolving member, and the substrate electrodes are attached on the side of the turning holders, the size of the substrate electrodes can be formed in the substantially same shape and size of the substrates. Therefore, substantially uniform film formation conditions can be obtained for the entire substrates, so that highly precise film formation with highly uniform film thickness, film quality and the like can be performed.

Specifically and preferably, as in claim 7, the substrate holder has a revolving member rotated relative to the vacuum chamber, and turning holders rotated relative to the revolving member, the turning holders being capable of supporting the substrates, the turning holders are insulated from the revolving member, and supplied with the electric power via bearings abutted on the side of the turning holders, and the substrate electrodes are attached on the side of the turning holders.

As in the above configuration, by using the bearings in connection parts between the turning holders and the wiring members to which the sputtering power source to be supplied to the substrate electrodes is conducted, the generation of the foreign substances due to sliding contact between the members can be suppressed, so that the cleanliness level of the film can be improved.

### Effect of the Invention

With the bias sputtering device according to claim 1, the ranges of the value of applicable voltage can be set higher than the conventional value, and the generation of the foreign substances is suppressed, so that the cleanliness level of the films can be improved.

With the bias sputtering device according to claims 2 and 4, the substrates are arranged in the ranges where the self-bias effect emerging in the substrate electrodes is reflected, and by changing the predetermined distance between the substrate electrodes and the substrates, the self-bias effect to be reflected to the substrates can be adjusted.

Further, with the bias sputtering device according to claims 3 and 7, the foreign substances are not generated, so that the cleanliness level of the films can be improved.

Further, with the bias sputtering device according to claims 5 and 6, the uniform film formation conditions can be obtained for the entire substrates, so that highly uniform and highly precise film formation can be performed.

### Brief Description of the Drawings

[Fig. 1] A concept diagram of a RF bias sputtering device according to a first embodiment of the present invention.
[Fig. 2] An illustrative top view of a substrate holder according to the first embodiment of the present invention.
[Fig. 3] An illustrative partially sectional view of the substrate holder according to the first embodiment of the present invention.
[Fig. 4] An illustrative top view of a substrate holder according to a second embodiment of the present invention.
[Fig. 5] An illustrative partially sectional view of the substrate holder according to the second embodiment of the present invention.

### Explanation of Reference Characters

M1, M2: Servomotor
Mbox: Matching box
d: Distance between substrate and substrate electrode
1: Sputtering device
10: Vacuum chamber
12: Substrate holder
14: Substrate
16: Shaft
17a, 17b, 23a: Gear
19a: Carbon brush
19b: Brush receiving portion
20: Power receiving member
21: Revolving member
21a: Attachment opening portion
23, 43: Turning holder
24: Ring shaped transmission member
24a, 24b: Tooth portion
28, 29a, 29b: Insulating member
30, 40: Substrate electrode
40a: Fixing member
31, 41: Wiring member
34, 36: Target
38: Spacer
39: Insulating coating
21b, 45: Bearing

### Best Modes for Carrying out the Invention

Hereinafter, one embodiment of the present invention will be described with reference to the drawings. It should be noted that members, arrangement and the like described below are only one example embodying the invention, and the present invention is not limited thereto. As a matter of course, the members, the arrangement and the like can be variously modified along the gist of the present invention.

### (First Embodiment)

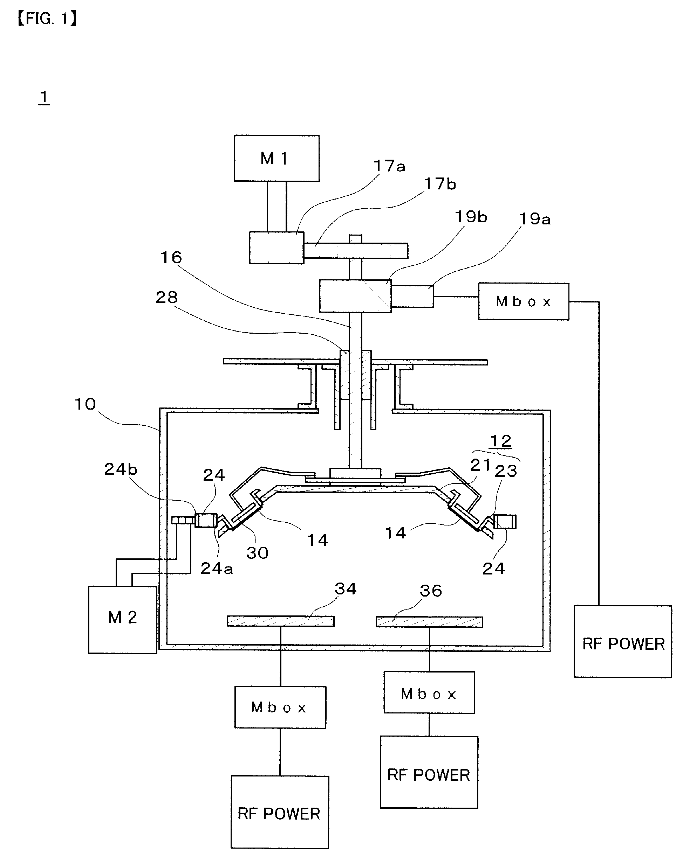

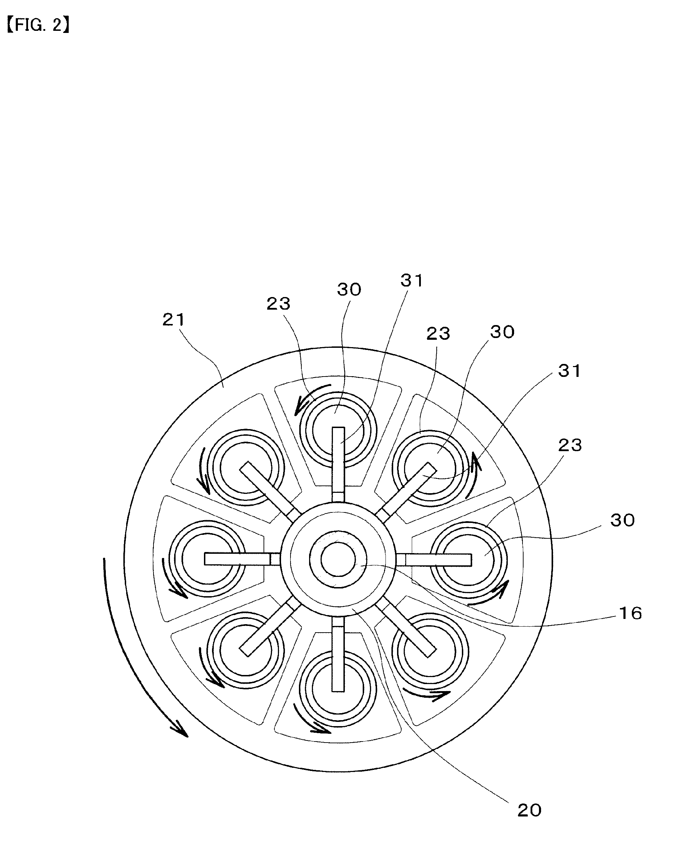

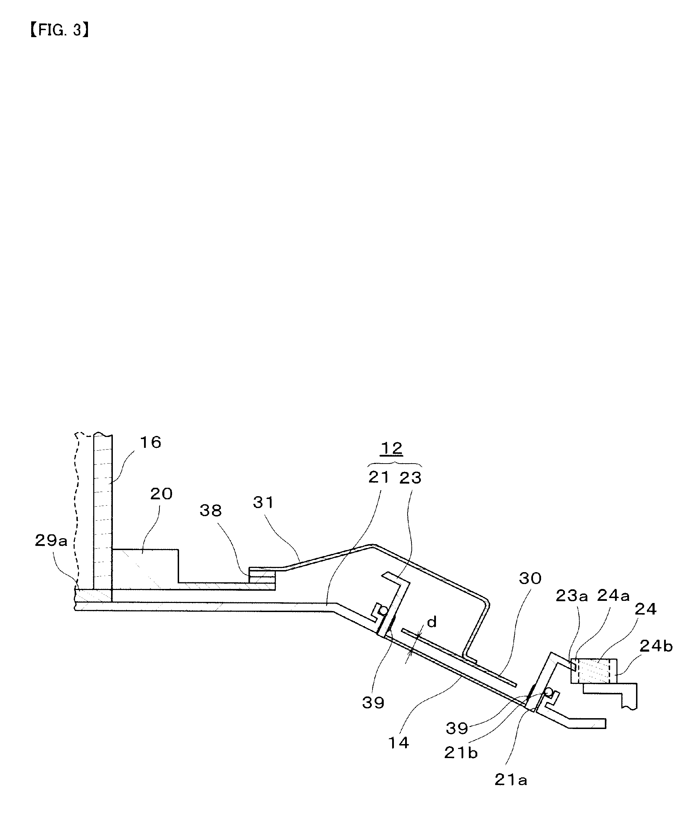

Figs. 1 to 3 show a first embodiment according to the present invention. Fig. 1 is a concept diagram of a RF bias sputtering device (hereinafter, a sputtering device 1) according to the first embodiment of the present invention. Fig. 2 is an illustrative top view of a substrate holder. Fig. 3 is an illustrative partially sectional view of the substrate holder.

Hereinafter, based on Figs. 1 to 3, constituent elements of the sputtering device 1 according to one embodiment of the present invention will be described.

The sputtering device 1 according to the present embodiment mainly includes a vacuum chamber 10, a shaft 16, a substrate holder 12, and targets 34, 36 as shown in the conceptual diagram of Fig. 1.

The vacuum chamber 10 according to the present embodiment is a stainless container normally used in a known film formation device, which is a cylindrical member to be vertically mounted.

This vacuum chamber 10 has a hole through which the shaft 16 described below passes, the hole being formed on the upper side thereof, and is electrically grounded so as to have ground potential.

It should be noted that the inside of the vacuum chamber 10 is exhausted so that internal pressure thereof becomes predetermined pressure (such as about 3 × 10⁻² to 10⁻⁴ Pa) by an exhaust means (not shown).

From a gas introduction pipe (not shown), a process gas for generating plasma such as an Ar gas, and a reactive gas such as an O₂ gas and a N₂ gas can be appropriately introduced into the vacuum chamber 10 according to need.

The shaft 16 according to the present embodiment is a substantially pipe shaped stainless member which is rotatably supported on the vacuum chamber 10 via an insulating member 28 arranged in a part of the hole formed on the upper side of the vacuum chamber 10.

It should be noted that this insulating member 28 is made of insulator or resin. The shaft 16 is supported on the vacuum chamber 10 via this insulating member 28 so as to be rotatable relative to the vacuum chamber 10 while being electrically insulated from the vacuum chamber 10.

A gear 17b is fixed to an upper end of the shaft 16 (arranged on the outer side of the vacuum chamber 10). This gear 17b is meshed with a gear 17a on the output side of a servomotor M1.

Therefore, by driving the servomotor M1, rotation drive force is transmitted to the gear 17b via the gear 17a, so that the shaft 16 is rotated.

A brush receiving portion 19b is attached on the lower side of the gear 17b.

This brush receiving portion 19b is slid with a carbon brush 19a connected to a high frequency (RF) power source via a matching box.

With such a configuration, a RF power source is supplied to the shaft 16.

A revolving member 21 described below is attached to a lower end of the shaft 16 (positioned on the inner side of the vacuum chamber 10).

In a connection part between this revolving member 21 and the shaft 16, a copper power receiving member 20 connected to the RF power is attached.

It should be noted that the shaft 16 is moved in the up and down direction while maintaining airtightness in the vacuum chamber 10 by an air cylinder (not shown). With this operation, a position of the shaft 16 can be adjusted.

In such a way, distances between the revolving member 21 and turning holders 23 attached to the lower end of the shaft 16 and described below, and the targets 34, 36 described below can be adjusted by this air cylinder.

The substrate holder 12 according to the present embodiment mainly includes the revolving member 21 and the turning holders 23.

The revolving member 21 according to the present embodiment is a dome shaped stainless member, which is arranged on the upper side in the vacuum chamber 10 in a state that a center part thereof is supported on the lower end of the shaft 16.

It should be noted that this revolving member 21 has ground potential.

An insulating member 29a is arranged between the power receiving member 20 fixed to the lower end of the shaft 16 and the revolving member 21. In such a way, since the revolving member 21 is fixed to the shaft 16 via the insulating member 29a, the revolving member 21 is electrically insulated from the shaft 16.

Further, attachment opening portions 21a for attaching the turning holders 23 described below are provided at 8 predetermined positions of the revolving member 21 (positions distant from each other by a central angle of 45 degrees relative to a center of the revolving member 21). Ring shaped bearings 21b are arranged on the side of inner surfaces of the attachment opening portions 21a.

A ring shaped transmission member 24 is arranged on the outer edge side of the revolving member 21. The ring shaped transmission member 24 is attached on the side of the revolving member 21 via a bearing (not shown) so as to be rotatable relative to the revolving member 21. Tooth portions 24a, 24b are formed over the entire peripheries on the inner side and the outer side of this ring shaped transmission member 24.

The turning holders 23 according to the present embodiment hold substrates 14 as substantially cylindrical stainless members.

Gears 23a formed so as to extend in the radial direction of outer peripheral parts are integrally assembled on the side of upper ends of the turning holders 23.

Fixing flanges (not shown) are formed on the lower side of the turning holders 23. By fixing the substrates 14 to the fixing flanges, the substrates 14 are fixed to the turning holders 23. A fixing method of the substrates 14 is not limited to this but can be appropriately changed within a range not departing from the gist of the present invention. For example, in addition to the fixing flanges, other fixing tools such as bolts and plate springs can be used.

It should be noted that in the present embodiment, since the eight turning holders 23 are attached to the revolving member 21, there are the eight turning holders 23 having the same shape. However, as a matter of course, the number of the turning holders 23 can be changed to the arbitrary number according to need.

The substrates 14 held by the turning holders 23 are appropriately selected according to need.

For example, in a case where an optical device is manufactured, materials having light permeability such as disc, plate or lens shaped resin (such as polyimide) and quartz are selected. In a case where an electronic device is manufactured, semiconductor substrates such as Si substrates and GaAs substrates are used.

Substrate electrodes 30 installed in the turning holders 23 are substantially disc shaped stainless members arranged on the back side of the substrates 14 (on the opposite side to surfaces facing the targets 34, 36), and electrically connected to the power receiving member 20 which is connected to the RF power via wiring members 31.

The wiring members 31 are members manufactured with the same material as the substrate electrodes 30 and have one ends fixed to the power receiving member 20. The other ends thereof are fixed to the substrate electrodes 30 by welding so as to be integrated with the substrate electrodes 30. The one ends of the wiring members 31 are reliably fixed to the power receiving member 20 by fastening members. Therefore, the substrate electrodes 30 are held at predetermined positions with required strength.

The targets 34, 36 according to the present embodiment are disc or substantially rectangular shaped members having surfaces onto which film formation materials to be deposited on the substrates 14 are jointed, capable of sputtering the film formation materials toward the substrates due to collisions of ions generated in the plasma. As the film formation materials, for example, metals such as Si, Nb, Al, Ta, and Cu, insulators such as SiO₂, Nb₂O₅, and Al₂O₃, or the like can be appropriately selected according to need. In the present embodiment, two kinds of the targets 34, 36 are provided. However, the number of the targets 34, 36 can also be arbitrarily changed according to need.

The targets 34, 36 are arranged on the lower side in the vacuum chamber 10 so as to face the substrates 14 arranged in the turning holders 23.

The RF power to be applied to the substrate electrodes 30 and the targets 34, 36 is supplied while being matched by a matching box Mbox. As the RF power, power having a frequency of about 10 to 100 MHz can be used.

As described above, on the upper side in the vacuum chamber 10, the shaft 16 passes through from the upper side of an outer part of the vacuum chamber 10, and attached so as to rotatable relative to the vacuum chamber 10.

This rotation is conducted to the shaft 16 by transmitting the rotation drive force of the servomotor M1 to the gears 17a, 17b. As the same time as the rotation drive force, by the brush receiving portion 19b slid with the carbon brush 19a which is connected to the high frequency (RF) power source via the matching box, the RF power source is supplied to the shaft 16.

The revolving member 21 is arranged on the side of the lower end of the shaft 16, and the eight turning holders 23 are arranged in this revolving holder 21 in the present embodiment.

The targets 34, 36 are arranged on the lower side in the vacuum chamber 10 so as to face the substrates 14 arranged in the turning holders 23. The RF power is supplied from the RF power source to the targets 34, 36 via matching boxes Mbox.

Next, relationships between the above members will be described.

The eight turning holders 23 are respectively attached to the attachment opening portions 21a formed in the revolving member 21. The turning holders 23 are fitted into the attachment opening portions 21a of the revolving member 21 from the upper side so as to be easily attached thereto.

At this time, the outer peripheral parts of the turning holders 23 are arranged and supported on the bearings 21b arranged in the attachment opening portions 21a. Thus, the turning holders 23 are supported so as to be rotatable relative to the revolving member 21.

The turning holders 23 are formed into a substantially cylindrical shape. Thus, when the turning holders are attached to the attachment opening portions 21a of the revolving member 21, circular opening areas are formed so as to pass through the revolving member 21 in the front and back surface direction.

In a state that the turning holders 23 are attached to the revolving member 21, the gears 23a formed on the outer peripheral side on the upper side of the turning holders 23 are exposed on the upper side of the attachment opening portions 21a.

The gears 23a formed on the outer peripheral side of the turning holders 23 are arranged so as to be meshed with the tooth portion 24a formed on the inner side of the ring shaped transmission member 24 which is rotatably arranged on the outer edge side of the revolving member 21. With such a configuration, by rotating the tooth portion 24b formed on the outer side of the ring shaped transmission member 24 by a servomotor M2, the gears 23a of the turning holders 23 meshed with the tooth portion 24b which is formed on the inner side of the ring shaped transmission member 24 can be rotated. In such a way, the turning holders 23 can turn themselves while being attached to the revolving member 21.

It should be noted that the tooth portions 24a, 24b formed in the ring shaped transmission member 24 have insulating coatings so as to be electrically insulated from the turning holders 23.

The substrates 14 are respectively fixed on the lower side of the turning holders 23 so that film formation surfaces thereof are directed downward. That is, the substrates 14 are fixed so as to close the opening areas on the lower side of the turning holders 23. As a matter of course, the substrates 14 may be fixed by means of the other fixing means such as jigs for supporting the substrates 14 and adhesives.

At this time, in order not to generate convex and concave parts around the film formation surfaces of the substrates 14, heights of a lower surface of the revolving member 21 and the film formation surfaces of the substrates 14 may be made even and fixed.

As described above, by forming the substrate holder 12 by assembling the revolving member 21 and the turning holders 23, the turning holders 23 have a structure capable of turning themselves while being attached to the revolving member 21 which is revolving. That is, the substrate holder 12 can perform a self-revolving motion. Therefore, since the substrates 14 attached to the turning holders 23 also perform the self-revolving motion, uniform film formation can be performed to the substrates 14.

The substrate electrodes 30 are arranged at the positions distant from back surfaces of the substrates 14 by a predetermined distance so as to face the back surfaces of the substrates 14 in parallel.

At this time, since the substrate electrodes 30 are arranged so as not to be in contact with the revolving member 21 and the turning holders 23, the RF power applied to the power receiving member 20 is supplied to the substrate electrodes 30 via the wiring members 31. Since the wiring members 31 are fixed to the power receiving member 20 fixed on the side of the revolving member 21, the substrate electrodes 30 fixed to the wiring members 31 are also rotated with the revolving member 21. That is, the substrate electrodes 30 are rotated with the revolving member 21. Therefore, the substrate electrodes 30 are arranged at the predetermined positions on the back side of the substrates 14 irrespective of turning motions of the turning holders 23.

The substrate electrodes 30 are arranged so as to be distant from the substrates 14 by the predetermined distance (d). The distance d between the substrates 14 and the substrate electrodes 30 (more precisely, the distance d between the back surfaces of the substrates 14 and surfaces of the substrate electrodes 30; hereinafter, referred to as the distance d) is set within a range where a self-bias effect by the substrate electrodes 30 is reflected to the substrates 14. The self-bias effect to be reflected to the substrates 14 can be adjusted by changing the distance d. As a matter of course, self-bias potential may be adjusted by changing sputtering power.

In accordance with film formation conditions, in the present embodiment, when the distance d is not more than about 20 mm, the self-bias effect by the substrate electrodes 30 influences the substrates 14. As a result of a film formation experiment with changing the film formation conditions such as the materials of the substrates 14, a value of the RF power, and an atmosphere of the film formation, a favorable film was obtained with the distance d within a range from 0.5 to 10 mm. Thus, the distance d is preferably within a range from not less than 0.5 mm and not more than 10 mm. The self-bias effect is adjusted by changing the distance d or the value of the RF power. As a matter of course, the distance d is adjusted within a range from 0.5 to 10 mm.

The distance d can be adjusted by sandwiching and fixing conductive spacers 38.

The spacers 38 are conductive members having arbitrary thickness arranged in connection parts between the power receiving member 20 and the wiring members 31 while being sandwiched between these members.

The power receiving member 20, the wiring members 31, and the spacers 38 are fixed by means of fastening members (not shown) such as bolts capable of passing through and fastening these members.

With such a configuration, since the substrate electrodes 30 are formed integrally with the wiring members 31, attachment heights of the substrate electrodes 30 to the turning holders 23 can be adjusted by changing heights (the thickness) of the spacers 38 sandwiched in the connection parts between the power receiving member 20 and the wiring members 31.

It should be noted that in the present embodiment, although the wiring members 31 are fixed to the power receiving member 20 on the side of the revolving member 21, the wiring members 31 may be fixed on the side of the revolving member 21 via insulating spacer members and conducted with the power receiving member 20 via bendable conductive members.

It should be noted that the heights of the wiring members 31 may be adjusted by screws in place of the spacers 38. In this case, the power receiving member 20 and the wiring members 31 may be fixed by bolts (not shown), and in accordance with upward and downward movement of the screws fitted into screw holes (not shown) formed on the side of the revolving member 21, fixing parts between the power receiving member 20 and the wiring members 31 may be formed so as to be movable upward and downward. With such a configuration, the heights of the wiring members 31 and the substrate electrodes 30 can be moved upward and downward in accordance with rotation of the screws. Thus, the heights can be easily and accurately adjusted.

Further, in the connection parts with the power receiving member 20, the wiring members 31 is attached to an actuator in which upward and downward movement can be controlled, so that by linking with the film formation conditions such as thickness of the substrates 14, film formation speed, and the film formation materials, the arrangement positions of the substrate electrodes 30 can be controlled.

As a matter of course, the substrate electrodes 30 and the wiring members 31 may be fixed by bolts, so that the positions of the substrate electrodes are adjusted in connection parts thereof.

In the present embodiment, the distance d is adjusted for each of the eight turning holders 23. However, by integrally forming the eight substrate electrodes 30, the distance d can be collectively set.

For example, a ring shaped conductive member (not shown) having high rigidity is attached on the upper side of the power receiving member 20 while the shaft 16 is inserted, and a position of this ring shaped member can be adjusted in the up and down direction while maintaining a conductive state with the power receiving member 20. By fixing all the wiring members 31 to this ring shaped member, the distance d can be collectively set. This ring shaped member can be moved upward and downward by sandwiching a conductive spacer with the power receiving member 20. As a matter of course, the ring shaped member can also be moved upward and downward by means of a screw. With such a configuration, the distance d between the substrates 14 and the substrate electrodes 30 at eight points can be collectively adjusted, so that workability of the sputtering device 1 can be improved, that is, cost of a film formation process can be reduced.

Size of the substrate electrodes 30 is determined in consideration with size of the substrates 14. The substrate electrodes 30 are formed so as to have a diameter of 80 to 98% relative to a diameter of the substrates 14. Particularly, the size is preferably not less than 90% of the size of the substrates 14. In the present embodiment, since the disc shaped substrates 14 have the diameter of 100 mm, the diameter of the substrate electrodes 30 is 80 to 98 mm.

When the substrate electrodes 30 are too small relative to the size of the substrates 14, it is difficult to have a uniform self-bias effect to be reflected to the surfaces of the substrates 14. Thus, there is a possibility that thickness and film quality of deposited layers formed on the substrates 14 are not uniform.

Meanwhile, when the substrate electrodes 30 are too close to other members such as the turning holders 23, there is a fear that electric discharge is generated between the substrate electrodes and the substrate holder 12, so that the supplied sputtering power becomes unstable. Therefore, in a case where the size of the substrate electrodes 30 is formed to be not less than about 90% relative to the diameter of the substrates 14, the turning holders 23 have insulating coatings 39 in areas close to the substrate electrodes 30. The insulating coatings 39 are formed on predetermined surfaces of the turning holders 23 by thermal spraying.

An effect of respectively attaching the substrate electrodes 30 on the side of the back surfaces of the substrates 14 will be described.

Since the RF power source is supplied to the substrate electrodes 30 arranged on the side of the back surfaces of the substrates 14, there is no need for applying the RF to the entire revolving member 23. Since an area to which the RF current is applied is small, ranges of values of voltage and the current to be applicable to the substrates 14 can be set higher than conventional values, so that density of the ions can be increased. Thus, the film quality can be improved to be fine and process time can be shortened.

Since the substrate electrodes 30 are not in contact with the turning holders 21, generation of foreign substances such as powder dust due to abrasion by sliding contact between the substrate electrodes 30 and the turning holders 23 is prevented, so that a cleanliness level of the films can be improved. Further, due to a simple structure, an increase in the number of parts is suppressed, so that cost of equipment can be reduced.

The film formation materials are not easily deposited on the revolving member 21 positioned in the vicinity of the substrates 14. Thus, even upon the ion collisions due to a bombardment process, the films are not exfoliated, so that the foreign substances (particles) adhered on the substrate electrodes 30 can be reduced. Therefore, the cleanliness level of the films and yield can be improved. Further, since the thin film materials adhered and deposited on the revolving member 21 and the turning holders 23 can be reduced, time required for removing the thin film materials (chamber maintenance time) can be shortened and an equipment operation rate is improved.

Further, since the substrate electrodes 30 are arranged so as to be distant from the substrates 14 by the predetermined distance in parallel, uniform film formation conditions are maintained in the film formation surfaces of the substrates 14, so that highly precise film formation with highly uniform film thickness and film quality can be performed.

The substrate electrodes 30 can be applied to the sputtering device 1 in which the substrate holder 12 is provided with a self-revolving mechanism. Thus, there is no need for a correcting plate for adjusting distribution of the film thickness which is adopted in a substrate holder provided only with a revolving mechanism. As a matter of course, the substrate electrodes 30 according to the present embodiment can also be applied to a bias sputtering device in which the substrate holder 12 is provided only with the revolving mechanism, and the ranges of the values of the voltage and the current to be applicable to the substrates 14 can be extended, so that the cleanliness level of the deposited films can be improved.

In the present embodiment, the bipolar RF bias sputtering device (the sputtering device 1) is formed as the present invention. However, the configuration according to the present invention can be applied to a sputtering device in which the current is applied to the substrates 14. For example, a tripolar or quadrupolar sputtering device using stabilizing electrodes may be formed.

In the present embodiment, although the RF power source is used as a sputtering power source, a DC power source can be used. In a case where the DC power source is used, the same effect as the sputtering device 1 according to the present embodiment can be obtained though the sputtering cannot be performed to the insulators.

It should be noted that as a matter of course, non-reactive sputtering can be performed without introducing an active gas such as O₂ and N₂ in the film formation.

A shutter (not shown) to be controlled to open and close may be provided on the upper side of the targets 34, 36 and an opening degree of the shutter may be adjusted, so that the targets 34, 36 which are sputtering and amounts of the sputtering can be adjusted.

### (Second Embodiment)

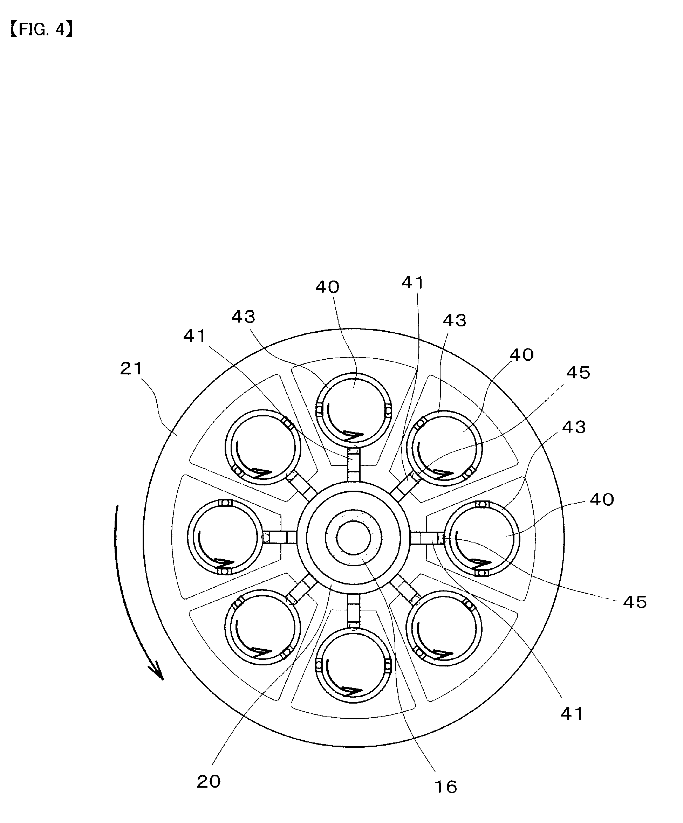

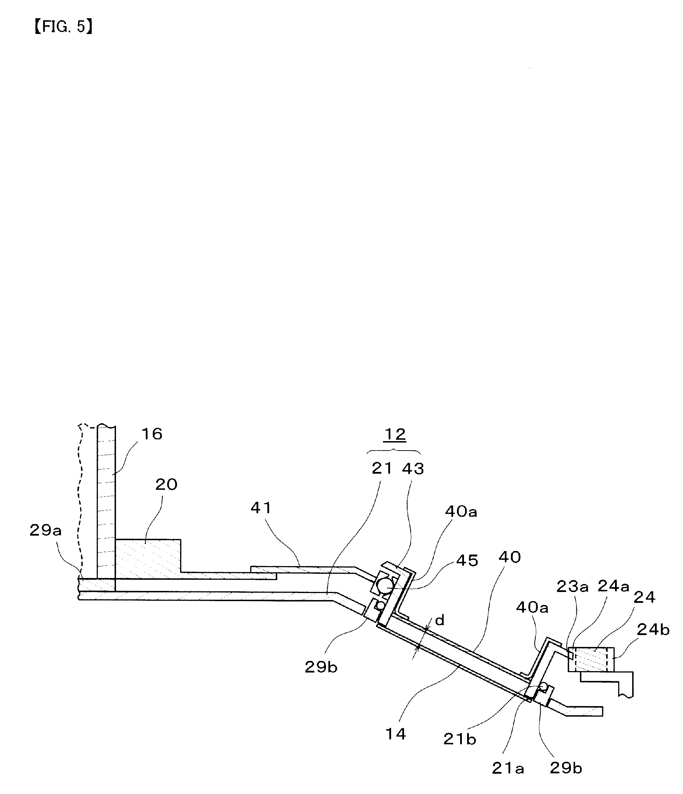

Figs. 4 and 5 show a second embodiment of the present invention. Fig. 4 is an illustrative top view of a substrate holder. Fig. 5 is an illustrative partially sectional view of the substrate holder.

It should be noted that in the following embodiment, the same members, arrangement and the like as the first embodiment will be given the same reference characters, and detailed description thereof will be omitted.

In the present embodiment, there is a difference in an attachment structure of substrate electrodes 40 from the sputtering device 1 according to the first embodiment. The substrate electrodes 40 according to the present embodiment are fixed to turning holders 43 and rotated with the turning holders 43.

The substrate electrodes 40 are substantially disc shaped stainless members which are fixed on the side of the turning holders 43 by fixing members 40a so as to be arranged on the side of the back surfaces of the substrates 14 relative to the targets 34, 36. The turning holders 43 are electrically connected to wiring members 41 and the power receiving member 20 via bearings 45 abutted with outer peripheral parts of the turning holders 43. Thus, the RF power is supplied to the substrate electrodes 40 via the turning holders 43.

The turning holders 43 are attached to the revolving member 21 via insulating members 29b so as to be electrically insulated from the revolving member 21.

As well as a case of the first embodiment, the substrate electrodes 40 are arranged at positions distant from the back surfaces of the substrates 14 by the predetermined distance (d) so as to face the substrates 14 in parallel.

The distance d is set within a range where the self-bias by the substrate electrodes 40 is emerging and reflected to the substrates 14. It should be noted that in the present embodiment, the distance d is also preferably not less than 0.5 mm and not more than 10 mm.

The self-bias effect to be reflected to the substrates 14 can be adjusted by changing the distance d, and also adjusted by changing the value of the RF power.

The distance d can be adjusted by changing the positions of the substrate electrodes 40 at the time of attaching the substrate electrodes 40 to the turning holders 43.

The substrate electrodes 40 are fixed to the turning holders 43 so as to be arranged on the entire back surfaces of the substrates 14. That is, even in a state that the turning holders 43 do not have the insulating coatings 39, the substrate electrodes 40 can be formed in the substantially same shape and size as the substrates 14. Since an influence of the self-bias effect to be reflected to the surfaces of the substrates 14 can be made uniform, the thickness and the film quality of the deposited layers formed on the substrates 14 can be made uniform.

By conducting the turning holders 43 and the wiring members 41 via the bearings 45, as in a case where the wiring members 41 are in sliding contact with the outer peripheral parts of the turning holders 43, the generation of the foreign substances such as the powder dust due to the abrasion of the members can be prevented, so that the cleanliness level of the films can be improved.

## Claims

1. A bias sputtering device, comprising:
a substrate holder having a self-revolving mechanism for supporting substrates in a vacuum chamber;
substrate electrodes provided on the side of the substrate holder; and
targets arranged so as to face the substrates, the bias sputtering device for applying electric power to the substrate electrodes and the targets and generating a plasma between the substrate electrodes and the targets, so that thin films are formed on surfaces of the substrates, wherein
the substrate electrodes are provided only on the side of back surfaces of the substrates supported by the substrate holder, and
the substrate electrodes and the substrates are arranged so as to be distant from each other by a predetermined distance.

2. The bias sputtering device according to claim 1, wherein
the predetermined distance between the substrate electrodes and the substrates is not less than 0.5 mm and not more than 10 mm.

3. The bias sputtering device according to claim 1, wherein
the substrate holder has a revolving member rotated relative to the vacuum chamber, and turning holders rotated relative to the revolving member, the turning holders being capable of supporting the substrates, and
the substrate electrodes are supported on one ends of wiring members directly or indirectly connected to an external power source on the other ends, and insulated from both of the turning holders and the revolving member.

4. The bias sputtering device according to claim 1, wherein
the substrate holder has a revolving member rotated relative to the vacuum chamber, and turning holders rotated relative to the revolving member, the turning holders being capable of supporting the substrates,
the substrate electrodes are supported on one ends of wiring members directly or indirectly connected to an external power source on the other ends, and insulated from both of the turning holders and the revolving member, and
the predetermined distance between the substrate electrodes and the substrates is adjustable by changing attachment positions of the wiring members to the revolving member.

5. The bias sputtering device according to claim 1, wherein
the substrate holder has a revolving member rotated relative to the vacuum chamber, and turning holders rotated relative to the revolving member, the turning holders being capable of supporting the substrates,
the substrate electrodes are supported on one ends of wiring members directly or indirectly connected to an external power source on the other ends, and insulated from both of the turning holders and the revolving member,
the predetermined distance between the substrate electrodes and the substrates is adjustable by changing attachment positions of the wiring members to the revolving member, and
the turning holders respectively have insulating coatings on surfaces in predetermined parts thereof in the vicinity of the substrate electrodes.

6. The bias sputtering device according to claim 1, wherein
the substrate holder has a revolving member rotated relative to the vacuum chamber, and turning holders rotated relative to the revolving member, the turning holders being capable of supporting the substrates,
the turning holders are insulated from the revolving member, and
the substrate electrodes are attached on the side of the turning holders.

7. The bias sputtering device according to claim 1, wherein
the substrate holder has a revolving member rotated relative to the vacuum chamber, and turning holders rotated relative to the revolving member, the turning holders being capable of supporting the substrates,
the turning holders are insulated from the revolving member, and supplied with the electric power via bearings abutted on the side of the turning holders, and
the substrate electrodes are attached on the side of the turning holders.

## Patentansprüche

1. Vorspannungs-Sputtervorrichtung, mit:
einem Substrathalter mit einem Selbstdrehmechanismus zum Halten von Substraten in einer Vakuumkammer;
Substratelektroden, die auf der Seite des Substrathalters vorgesehen sind; und
Materialquellen, die so angeordnet sind, dass sie den Substraten zugewandt sind, wobei die Vorspannungs-Sputtervorrichtung zur Zufuhr elektrischer Leistung zu den Substratelektroden und den Materialquellen und zur Erzeugung eines Plasmas zwischen den Substratelektroden und den Materialquellen ausgelegt ist, so dass dünne Schichten auf Oberflächen der Substrate gebildet werden, wobei
die Substratelektroden nur auf der Seite von Rückseitenfläche der Substrate, die von der Substrathalterung gehalten sind, vorgesehen sind, und
die Substratelektroden und die Substrate so angeordnet sind, dass sie entsprechend einem vorbestimmten Abstand voneinander entfernt sind.

2. Vorspannungs-Sputtervorrichtung nach Anspruch 1, wobei der vorbestimmte Abstand zwischen den Substratelektroden und den Substraten nicht kleiner als 0,5 mm und nicht größer als 10 mm ist.

3. Vorspannungs-Sputtervorrichtung nach Anspruch 1, wobei
der Substrathalter ein Drehelement, das relativ zu der Vakuumkammer gedreht ist, und Umkehrhalter, die relativ zu dem Drehelement gedreht sind, aufweist, wobei die Umkehrhalter für das Halten der Substrate ausgebildet sind, und
die Substratelektroden an einem Ende von Verdrahtungselementen gehalten sind, die an dem anderen Ende direkt oder indirekt mit einer externen Leistungsquelle verbunden sind, und sowohl zu den Umkehrhaltern als auch dem Drehelement isoliert sind.

4. Vorspannungs-Sputtervorrichtung nach Anspruch 1, wobei
der Substrathalter ein Drehelement, das relativ zu der Vakuumkammer gedreht ist, und Umkehrhalter, die relativ zu dem Drehelement gedreht sind, aufweist, wobei die Umkehrhalter zum Halten der Substrate ausgebildet sind,
die Substratelektroden an einem Ende von Verdrahtungselementen gehalten sind, die an dem anderen Ende direkt oder indirekt mit einer externen Leistungsquelle verbunden sind, und sowohl zu den Umkehrhaltern als auch dem Drehelement isoliert sind, und
der vorbestimmte Abstand zwischen den Substratelektroden und den Substraten durch Änderung von Befestigungspositionen der Verdrahtungselementen zu dem Drehelement einstellbar ist.

5. Vorspannungs-Sputtervorrichtung nach Anspruch 1, wobei
der Substrathalter ein Drehelement, das relativ zu der Vakuumkammer gedreht ist, und Umkehrhalter, die relativ zu dem Drehelement gedreht sind, aufweist, wobei die Umkehrhalter zum Halten der Substrate ausgebildet sind,
die Substratelektroden an einem Ende von Verdrahtungselementen gehalten sind, die an dem anderen Ende direkt oder indirekt mit einer externen Leistungsquelle verbunden sind, und sowohl zu den Umkehrhaltern als auch dem Drehelement isoliert sind,
der vorbestimmte Abstand zwischen den Substratelektroden und den Substraten durch Änderung von Befestigungspositionen der Verdrahtungselementen zu dem Drehelement einstellbar ist, und
die Umkehrhalterjeweils isolierende Beschichtungen auf Oberflächen in vorbestimmten Teilen davon in der Nähe der Substratelektroden aufweisen.

6. Vorspannungs-Sputtervorrichtung nach Anspruch 1, wobei
der Substrathalter ein Drehelement, das relativ zu der Vakuumkammer gedreht ist, und Umkehrhalter, die relativ zu dem Drehelement gedreht sind, aufweist, wobei die Umkehrhalter zum Halten der Substrate ausgebildet sind,
die Unterhalter zu dem Drehelement isoliert sind, und
die Substratelektroden an der Seite der Umkehrhalter angebracht sind.

7. Vorspannungs-Sputtervorrichtung nach Anspruch 1, wobei
der Substrathalter ein Drehelement, das relativ zu der Vakuumkammer gedreht ist, und Umkehrhalter, die relativ zu dem Drehelement gedreht sind, aufweist, wobei die Umkehrhalter zum Halten der Substrate ausgebildet sind,
die Unterhalter zu dem Drehelement isoliert sind und mit der elektrischen Leistung über Lager versorgt sind, die auf der Seite der Umkehrhalter anliegend sind, und
die Substratelektroden auf der Seite der Umkehrhalter angebracht sind.

## Revendications

1. Un dispositif polariseur pulvérisateur, comprenant :
un support de substrats équipé d'un mécanisme tournant sur lui-même pour soutenir des substrats dans une chambre à vide ;
des électrodes de substrats situées sur le côté du support de substrats ; et
des cibles disposées de façon à faire face aux substrats, et le dispositif polariseur pulvérisateur fournit de l'énergie électrique aux électrodes de substrats et aux cibles pour créer un plasma entre les électrodes de substrats et les cibles, de façon à former des films minces sur les surfaces des substrats, où
les électrodes de substrats ne sont que sur le côté de l'envers des surfaces des substrats soutenus par le support de substrats, et
les électrodes de substrats et les substrats sont disposés de façon à se situer à une distance prédéfinie.

2. Le dispositif polariseur pulvérisateur selon la Revendication 1, où
la distance prédéfinie entre les électrodes de substrats et les substrats n'est ni inférieure à 0,5 mm, ni supérieure à 10 mm.

3. Le dispositif polariseur pulvérisateur selon la Revendication 1, où
le support de substrats comporte un élément tournant par rapport à la chambre à vide, et des supports tournants par rapport à l'élément tournant, ces supports tournants pouvant soutenir les substrats, et
les électrodes de substrats sont soutenues à une extrémité d'éléments de câblage raccordés directement ou indirectement à une source d'alimentation externe à l'autre extrémité, et isolées à la fois par rapport aux supports tournants et à l'élément tournant.

4. Le dispositif polariseur pulvérisateur selon la Revendication 1, où
le support de substrat comporte un élément tournant par rapport à la chambre à vide, et des supports tournants par rapport à l'élément tournant, ces supports tournants pouvant soutenir les substrats,
les électrodes de substrats sont soutenues à une extrémité d'éléments de câblage raccordés directement ou indirectement à une source d'alimentation externe à l'autre extrémité, et isolées à la fois par rapport aux supports tournants et à l'élément tournant, et
la distance prédéfinie entre les électrodes de substrats et les substrats est réglable par modification de la position de fixation des éléments de câblage sur l'élément tournant.

5. Le dispositif polariseur pulvérisateur selon la Revendication 1, où
le support de substrat comporte un élément tournant par rapport à la chambre à vide, et des supports tournants par rapport à l'élément tournant, ces supports tournants pouvant soutenir les substrats,
les électrodes de substrats sont soutenues à une extrémité d'éléments de câblage raccordés directement ou indirectement à une source d'alimentation externe à l'autre extrémité, et isolées à la fois par rapport aux supports tournants et à l'élément tournant,
la distance prédéfinie entre les électrodes de substrats et les substrats est réglable par modification de la position de fixation des éléments de câblage sur l'élément tournant, et
les supports tournants ont des revêtements isolants à des emplacements prédéfinis de leur surface au voisinage des électrodes de substrats.

6. Le dispositif polariseur pulvérisateur selon la Revendication 1, où
le support de substrat comporte un élément tournant par rapport à la chambre à vide, et des supports tournants par rapport à l'élément tournant, ces supports tournants pouvant soutenir les substrats,
les supports tournants sont isolés de l'élément tournant, et
les électrodes de substrats sont fixées sur le côté des supports tournants.

7. Le dispositif polariseur pulvérisateur selon la Revendication 1, où
le support de substrat comporte un élément tournant par rapport à la chambre à vide, et des supports tournants par rapport à l'élément tournant, ces supports tournants pouvant soutenir les substrats,
les supports tournants sont isolés par rapport à l'élément tournant et alimentés en énergie électrique par des paliers aboutés sur le côté des supports tournants, et
les électrodes de substrats sont fixées sur le côté des supports tournants.
